# EUROPEAN PATENT SPECIFICATION

(11) **EP 2 495 774 B1**
(45) Date of publication and mention of the grant of the patent: **18.07.2018**
(21) Application number: 10826634.7
(22) Date of filing: 22.10.2010
(51) Int. Cl.: H01L 33/48, H01L 33/60, H01L 33/50

(54) **LIGHT EMITTING DEVICE**
LICHTEMITTIERENDE VORRICHTUNG
DISPOSITIF LUMINESCENT

(30) Priority: 29.10.2009 JP 2009248903
(43) Date of publication of application: 05.09.2012
(73) Proprietor: Kyocera Corporation, Kyoto-shi, Kyoto 612-8501 (JP)
(72) Inventor: KATABE, Kousuke, Higashiomi-shi Shiga 529-1595 (JP); MORI, Yuki, Higashiomi-shi Shiga 529-1595 (JP); MIYAKE, Akira, Higashiomi-shi Shiga 529-1595 (JP); MATSUURA, Shingo, Higashiomi-shi Shiga 529-1595 (JP); MORI, Masayuki, Higashiomi-shi Shiga 529-1595 (JP)
(74) Representative: Viering, Jentschura & Partner mbB Patent- und Rechtsanwälte
(86) International application number: PCT/JP2010/068693
(87) International publication number: WO 2011/052502

(56) References cited:
- WO-A1-2009/082011
- WO-A1-2011/037184
- JP-A- 2006 332 618
- JP-A- 2007 227 868
- JP-A- 2007 234 637
- JP-A- 2007 242 738
- JP-A- 2007 242 738
- JP-A- 2008 147 513
- JP-A- 2008 147 513
- JP-A- 2009 099 923
- US-A1- 2005 219 835

## Description

### Technical field

The present invention relates to a light-emitting device including a light-emitting element.

### Background Art

In recent years, developments of light-emitting elements which are of the type having a light source including a light-emitting element have been under way. Such a light-emitting device with a light-emitting element is noteworthy for its feature as to power consumption or product lifetime. For example, in the field of residential luminaire technology, the light-emitting device with a light-emitting element is required to possess the capability of emitting light portions of a plurality of color temperatures in a selective manner.

By way of example, there is a light-emitting device designed so that light emitted from a light-emitting element undergoes reflection before being produced outwards (refer to Japanese Unexamined Patent Publications JP-A 2007-294867 and JP-A 2008-251685, for example). There has been a growing demand for a light-emitting device capable of production of light with a higher degree of luminous efficiency.

The document JP 2008 147513 discloses a light-emitting device having a frame portion, wherein no wavelength converter is provided.

The document WO 2009/082011 A1 discloses a light-emitting device according to the preamble of claim 1 wherein the light-emitting element is located above the bottom portion of the frame, which is provided with a wavelength converter.

Further background art is disclosed in the documents US 2005/0219835 A1 and JP2007242738.

### Summary of Invention

A photoelectric conversion device in accordance with one embodiment of the invention includes a substrate mounted with a light-emitting element; and a frame disposed on the substrate. The frame includes a first frame portion formed on the substrate so as to surround the light-emitting element, the first frame portion having an inner wall surface substantially perpendicular to an upper surface of the substrate, an upper end of the inner wall surface being positioned at a level higher than a level of an upper surface of the light-emitting element; and a second frame portion formed so as to surround the inner wall surface of the first frame portion when viewed in a plan view, the second frame portion having an inner periphery which is so shaped as to extend at an outward incline from a lower end of the inner periphery to an upper end thereof. The light-emitting device further includes a wavelength converter supported on the frame so as to be opposed in spaced relation to the substrate.

### Brief Description of Drawings

Fig. 1 is a sectioned perspective view showing a schematic overview of a light-emitting device according to an embodiment;
Fig. 2 is a sectional view of the light-emitting device according to the embodiment;
Fig. 3 is a sectional view of the light-emitting device related to the embodiment, illustrating part of the structure in enlarged dimension;

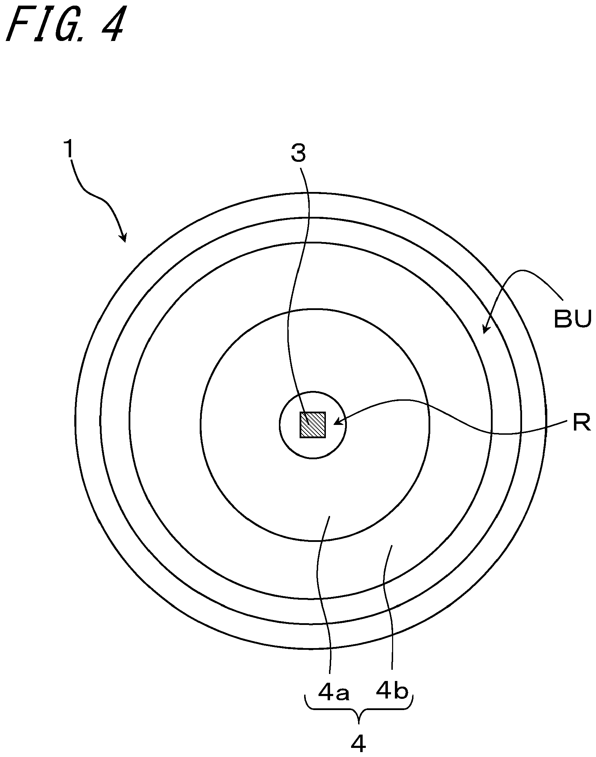

Fig. 4 is a plan view of the light-emitting device shown in Fig. 2;
Fig. 5 is a sectional view of the light-emitting device, illustrating a state where light emitted from a light-emitting element is reflected from a reflecting surface;
Fig. 6 is a sectional view of a modified example of the light-emitting device;
Fig. 7 is a plan view of the light-emitting device shown in Fig. 6;
Fig. 8 is a sectional view of a modified example of the light-emitting device; and
Fig. 9 is a plan view of the light-emitting device shown in Fig. 8.

### Description of Embodiments

Hereinafter, an embodiment of a light-emitting device pursuant to the invention will be described with reference to the accompanying drawings. It should be noted that the invention is not limited to the embodiment as set forth hereunder.

### <Structure of Photoelectric device>

A light-emitting device 1 according to the embodiment includes: a substrate 2; a light-emitting element 3 disposed on the substrate 2; a frame 4 disposed on the substrate 2 and surrounding the light-emitting element 3; and a wavelength converter 5 supported on the frame 4 and opposed to the light-emitting element 3 with a gap. For example, the light-emitting element 3 is a light-emitting diode, and emits light to the outside by exploiting electron-positive hole reunion in semiconductor-based p-n junction.

The substrate 2 has a mounting region R for the mounting of the light-emitting element 3. The substrate 2 is constructed of an insulating substrate made of a porous material such for example as aluminum oxide, titanium oxide, zirconium oxide, or yttrium oxide. The substrate 2, being made of a porous material, has a large number of fine pores formed at its surface. Light emitted from the light-emitting element 3 is shone on the surface of the substrate 2 while being diffusely reflected therefrom. In this way, the light emitted from the light-emitting element 3 is radiated in many directions through the diffused reflection; wherefore the light emitted from the light-emitting element 3 is restrained from convergence to a specific location.

Moreover, the substrate 2 can be made of a ceramic material such as alumina, mullite, or glass ceramics, or a composite material based on a mixture of two or more of those materials. Also, polymeric resin containing fine metal oxide particles in a dispersed state can be used for the substrate 2.

Further, the substrate 2 is formed with a wiring conductor configured to permit electrical conduction between an interior of the substrate 2 and an exterior thereof. The wiring conductor is made of an electrically conductive material such as tungsten, molybdenum, manganese, or copper. For example, the wiring conductor can be obtained by printing a metal paste, which is prepared by adding an organic solvent to powder of tungsten or the like, onto an upper surface of the substrate 2 in a predetermined pattern. Note that the surface of the wiring conductor exposed internally and externally of the substrate 2 is clad with a plating layer made of nickel, gold, or the like for protection against oxidation.

The light-emitting element 3 is mounted on the substrate 2 so as to lie in the mounting region R. More specifically, the light-emitting element 3 is electrically connected onto the wiring conductor formed on the substrate 2 via solder or an adhesive, for example.

The light-emitting element 3 includes a mounting substrate and an optical semiconductor layer formed on the mounting substrate. The mounting substrate may be of any given type in so far as it is capable of the growth of the optical semiconductor layer by means of chemical vapor deposition such as a metalorganic vapor deposition technique or molecular beam epitaxial growth technique. Examples of the material of construction of the mounting substrate include sapphire, gallium nitride, aluminum nitride, zinc oxide, silicon carbide, silicon, and zirconium diboride. The thickness of the mounting substrate falls in a range of 100 µm or more and 1000 µm or less.

The optical semiconductor layer is composed of a first semiconductor layer formed on the mounting substrate, a light-emitting layer formed on the first semiconductor layer, and a second semiconductor layer formed on the light-emitting layer.

For example, Group III-V semiconductors such as a Group-III nitride semiconductor, gallium phosphide, or gallium arsenide, or Group III nitride semiconductors such as gallium nitride, aluminum nitride, or indium nitride can be used for the first semiconductor layer, the light-emitting layer, and the second semiconductor layer. The thickness of the first semiconductor layer falls in a range of 1 µm or more and 5 µm or less. The thickness of the light-emitting layer falls in a range of 25 nm or more and 150 nm or less. The thickness of the second semiconductor layer falls in a range of 50 nm or more and 600 nm or less. Moreover, as the light-emitting element 3 thusly constructed, for example, an element capable of giving forth excitation light ranging in wavelength from 370 nm or more and 420 nm or less can be employed.

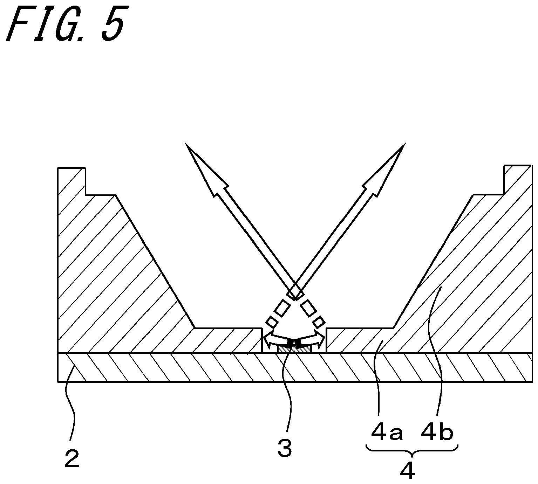

Fig. 5 is a sectional view of the light-emitting device 3, illustrating a state where excitation light emitted from the light-emitting element 3 is being reflected from the inner wall surface of a first frame portion 4a. In Fig. 5, there is shown the construction with the wavelength converter 5 and a sealing resin 6 removed. Note that the arrows depicted in Fig. 5 indicate the directions of travel of many light beams that will hereafter be described.

The frame 4 is attached onto the substrate 2 via, for example, solder or an adhesive. The frame 4 is composed of the first frame portion 4a and a second frame portion 4b disposed on the first frame portion 4a. Moreover, the inner wall surface of the frame 4 is defined by the inner wall surface of the first frame portion 4a and the inner periphery of the second frame portion 4b. Further, the outer wall surface of the frame 4 is defined by the outer wall surface of the first frame portion 4a and the outer wall surface of the second frame portion 4b.

Ceramic materials of the same composition are used for the first frame portion 4a and the second frame portion 4b. For example, a porous material such as aluminum oxide, titanium oxide, zirconium oxide, or yttrium oxide may be used. The frame 4, being made of a porous material just like the substrate 2, has a large number of fine pores formed at its surface. The light emitted from the light-emitting element 3 is diffusely reflected from the inner wall surface of the frame 4; wherefore the light emitted from the light-emitting element 3 is restrained from convergence to a specific location.

The first frame portion 4a surrounds the light-emitting element 3, with a spacing secured between them. The inner wall surface of the first frame portion 4a is circularly shaped when viewed in a plan view. The inner wall surface of the first frame portion 4a serves as a reflecting surface at which is reflected excitation light emitted from the light-emitting element 3. A single light-emitting element 3 is placed inside the first frame portion 4a of the frame 4. Since the inner wall surface of the first frame portion 4a is circularly shaped when viewed in a plan view and the single light-emitting element 3 is placed at the center of the circle defining the inner wall surface, it follows that many of the light beams emitted from the single light-emitting element 3 so as to travel in the planar direction can be evenly reflected from the circular inner wall surface of the first frame portion 4a.

In what follows, let it be assumed that a plurality of light-emitting elements 3 are arranged inside the first frame portion 4a of the frame 4. In this case, a larger number of light beams are produced in the region surrounded by the first frame portion 4a. Furthermore, the placement of a plurality of light-emitting elements 3 inside the first frame portion 4a gives rise to variations in the distance between one light-emitting element 3 and the inner wall surface of the first frame portion 4a. Therefore, light beams that travel from inside the first frame portion 4a toward the wavelength converter 5 without being reflected from the inner wall surface of the first frame portion 4a will be much more than those that travel toward the wavelength converter 5 after being reflected from the inner wall surface of the first frame portion 4a. In addition, the rate of light absorption by the light-emitting element 3 is increased, with the consequence that the light emitted from the light-emitting element 3 cannot be reflected efficiently from the inner wall surface of the first frame portion 4a.

As shown in Fig. 5, the first frame portion 4a is disposed on the substrate 2 and surrounds the light-emitting element 3, and the upper end of its inner wall surface is situated above the level of the upper surface of the light-emitting element 3. In this way, by adjusting the upper end of the inner wall surface of the first frame portion 4a to be higher in level than the upper surface of the light-emitting element 3, it is possible to cause diffused reflection of excitation light emitted upwardly from the light-emitting element 3 at the inner wall surface of the first frame portion 4a, and thus diffuse the excitation light beams in different traveling directions. In consequence, the excitation light emitted from the light-emitting element can be applied to the entire lower surface of the wavelength converter 5.

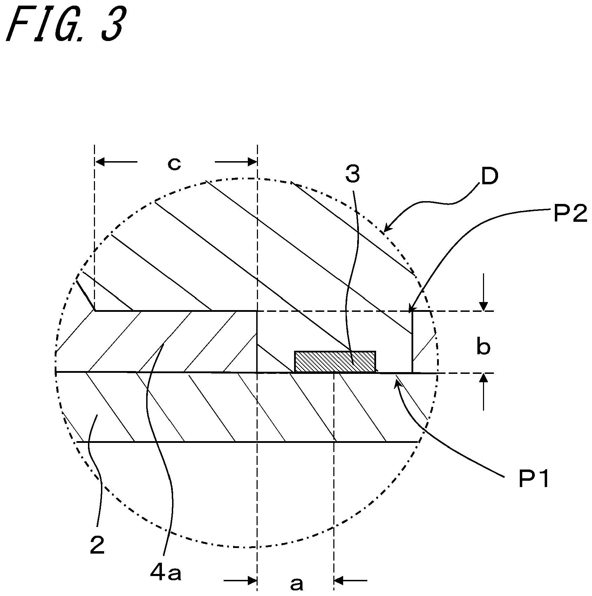

Moreover, as shown in Fig. 3, when the construction is viewed in a sectional view, the distance from the center of the light-emitting element 3 to the inner wall surface of the first frame portion 4a is represented as a, and also the distance between the level P1 of the lower surface of the light-emitting element 3 and the level P2 of the upper end of the inner wall surface of the first frame portion 4a is represented as b. According to the invention, the distance a and the distance b are so determined as to fulfill a condition that a tanθ ≤ b ≤ a tan β, wherein θ represents a half-value angle relative to the luminous intensity distribution in the light-emitting element 3, and β represents an angle at which 90%-luminosity with respect to peak luminosity is observed relative to the luminous intensity distribution in the light-emitting element 3. As used herein, the term "half-value angle" means the angle which a point where the light-emitting element 3 gives forth light forms with a point where the value of peak luminosity is reduced by half relative to the luminous intensity distribution of light emitted from the light-emitting element 3. For example, given that the value of peak luminosity in the luminous intensity distribution in the light-emitting element 3 mounted on the substrate 2 is 1 in terms of relative light intensity, then the angle θ corresponding to 50%-intensity relative to the luminous intensity distribution in the light-emitting element 3 is 10°, and the angle β corresponding to 90%-intensity relative to the luminous intensity distribution in the light-emitting element 3 is 50°.

Under a condition that b < a tanθ, since the quantity of light reflected from the inner wall surface of the first frame portion 4a is small, it follows that, when light is applied to the inner wall surface of the first frame portion 4a, fewer light beams undergo diffused reflection. On the other hand, under a condition that b > a tanβ, light is likely to be confined inside the first frame portion 4a.

With this in view, the light-emitting element and the first frame portion 4a are disposed in a relationship such that the condition that a tanθ ≤ b ≤ a tanβ can be fulfilled. By so doing, light emitted laterally from the light-emitting element is diffusely reflected from the inner wall surface of the first frame portion 4a, and the light beams thus enter the entire lower surface of the wavelength converter 5 with little unevenness. In consequence, the light emitted laterally from the light-emitting element reaches as far as the outer periphery of the wavelength converter 5, whereupon the light is wavelength-converted by the wavelength converter 5 as a whole. This leads to enhancement in the optical output capability and luminous efficiency of the light-emitting device. That is, the advantage is gained that the wavelength converter 5 can be wholly utilized for wavelength conversion with effectiveness. Note that the distance a is adjusted to fall in a range of 0.1 mm or more and 1.0 mm or less, for example. The distance b is adjusted to fall in a range of 0.01 mm or more and 1.2 mm or less, for example.

Moreover, the inner wall surface of the first frame portion 4a is disposed in an upstanding state so as to be substantially perpendicular to the upper surface of the substrate 2. As used herein, the expression "substantially perpendicular" means that, when the construction is viewed in a sectional view, the angle which a parallel line extending along the upper surface of the substrate 2 forms with a straight line extending along the inner wall surface of the first frame portion 4a falls in a range of 85° or more and 95° or less.

That is, the inner wall surface of the first frame portion 4a is made substantially perpendicular to the upper surface of the substrate 2 without any appreciable incline, while allowing radiation of light emitted from the light-emitting element 3. This permits of adjustment so that light beams emitted from the light-emitting element 3 are gathered in the region surrounded by the first frame portion 4a, and the gathered light beams are quickly diffused when traveling from the region surrounded by the first frame portion 4a toward the region surrounded by the second frame portion 4b. If the inner wall surface of the first frame portion 4a is not made substantially perpendicular to the upper surface of the substrate 2 but is inclined greatly, it will be difficult to collect light beams in the region surrounded by the first frame portion 4a. This leads to difficulty in adjustment to the direction of travel of light emitted from the light-emitting element 3, in consequence whereof there results lack of uniformity in light irradiation to the wavelength converter 5.

In the second frame portion 4b disposed on the first frame portion 4a, its inner periphery is so shaped as to extend at an outward incline from a lower end of the inner periphery to an upper end thereof, and the lower end of the inner periphery is located outwardly beyond the inner wall surface of the first frame portion 4a. The inner periphery of the second frame portion 4b is circularly shaped when viewed in a plan view. By forming the second frame portion 4b so that its inner periphery has a circular shape when viewed in a plan view, it is possible for light emitted from the light-emitting element 3 placed centrally of the frame 4 to be reflected from the circular inner periphery of the second frame portion 4b, whereby the light can be applied evenly to the entire lower surface of the wavelength converter 5.

A distance c, which is the distance from the lower end of the inner periphery of the second frame portion 4b to the upper end of the inner periphery of the first frame portion 4a, is adjusted to be longer than the distance a from the center of the light-emitting element 3 to the inner wall surface of the first frame portion 4a. By adjusting the distance c from the lower end of the inner periphery of the second frame portion 4b to the upper end of the inner wall surface of the first frame portion 4a to be longer than the distance a from the side surface of the light-emitting element 3 to the inner wall surface of the first frame portion 4a, it is possible for excitation light which has undergone total reflection at the wavelength converter 5 to be diffusely reflected from the upper surface of the first frame portion 4a once again and travel toward the wavelength converter 5. In consequence, the excitation light totally reflected from the wavelength converter 5 is diffusely reflected from the upper surface of the first frame portion 4a once again, whereupon the light can be applied to the entire lower surface of the wavelength converter 5.

Moreover, the inclined inner periphery of the second frame portion 4b may be formed with a metallic layer made for example of tungsten, molybdenum, copper, or silver, and a metallic plating layer made of nickel, gold, or the like for covering the metallic layer. The metallic plating layer has the capability of reflective dispersion of light emitted from the light-emitting element 3. Note that the angle of inclination of the inner periphery of the second frame portion 4b is adjusted to fall, for example, in a range of 55° or more and 70° or less with respect to the upper surface of the substrate 2.

Further, the upper end of the second frame portion 4b is internally stepped to provide a shoulder BU. The shoulder BU serves to support the wavelength converter 5. The shoulder BU, which is formed by cutting part of the top of the second frame portion 4b inwardly, is capable of supporting the end of the wavelength converter 5.

The sealing resin 6 is charged into the region surrounded by the first frame portion 4a and the second frame portion 4b. The sealing resin 6 has the capabilities of sealing the light-emitting element 3 and permitting transmission of light emitted from the light-emitting element 3 therethrough. With the light-emitting element 3 accommodated inside the first frame portion 4a and the second frame portion 4b, the sealing resin 6 is charged into the region surrounded by the first frame portion 4a and the second frame portion 4b so that its level is situated below the level of the shoulder BU. That is, the sealing resin 6 is charged until it comes to a level which is higher than the level of the upper surface of the first frame portion 4a but lower than the level of the shoulder BU. In consequence, the light emitted from the light-emitting element 3 is confined inside the first frame portion 4a under the effect of total reflection resulting from the difference in refractive index between the sealing resin 6 and a layer of air. This makes it possible to suppress light absorption by the light-emitting element 3 and the inner periphery of the first frame portion 4a, and thereby increase the luminous efficiency of the light-emitting device 3. Note that light-transmittable insulating resin such for example as silicone resin, acrylic resin, or epoxy resin is used as the sealing resin 6.

The wavelength converter 5 is supported on the shoulder BU of the second frame portion 4b so as to be opposed to the light-emitting element 3 with a gap. That is, the wavelength converter 5 is disposed on the second frame portion 4b, with a spacing secured between the wavelength converter 5 and the sealing resin 6 for sealing the light-emitting element 3.

Moreover, the upper surface of the sealing resin 6 and the lower surface of the wavelength converter 5 are located in parallel with each other. In consequence, the light emitted from the light-emitting element 3 enter the wavelength converter 5 after undergoing refraction or reflection evenly at the interface between the sealing resin 6 and the air layer, and can thus be uniformly wavelength-converted by the wavelength converter 5. This makes it possible to achieve enhancement in wavelength conversion efficiency, as well as to suppress unevenness in color of light emitted from the wavelength converter 5.

Further, the upper surface of the light-emitting element 3 and the lower surface of the wavelength converter 5 are located in parallel with each other. By virtue of the parallel arrangement of these surfaces, the light emitted from the light-emitting element 3 can readily enter the wavelength converter 5. This makes it possible to achieve enhancement in wavelength conversion efficiency and in light-emission luminance.

In addition, the upper surface of the light-emitting element 3, the lower surface of the wavelength converter 5, and the upper surface of the first frame portion 4a are located in parallel with one another. In consequence, the light emitted from the light-emitting element 3 can readily enter the wavelength converter 5, and also the light reflected therefrom can be reflected efficiently from the upper surface of the first frame portion 4a. This makes it possible to enhance the light-emission luminance of the light produced outwards. Moreover, the upper surface of the first frame portion 4a has the form of a diffusing surface. In this way, since the upper surface of the first frame portion 4a is configured for easy light reflection, it is possible to achieve further enhancement in light-emission luminance.

The wavelength converter 5 is bonded to the second frame portion 4b via an adhesive portion 7. The adhesive portion 7 is applied so as to extend from the end of the lower surface of the wavelength converter 5 to the side surface of the wavelength converter 5, and from there to the end of the upper surface of the wavelength converter 5.

For example, thermosetting resin such as polyimide resin, acrylic resin, epoxy resin, urethane resin, cyanate resin, silicone resin, or bismaleimide triazine resin can be used for the adhesive portion 7. Moreover, thermoplastic resin such as polyether ketone resin, polyethylene terephthalate resin, or polyphenylene ether resin can also be used for the adhesive portion 7.

The material used for the adhesive portion 7 is of the type having a thermal expansion coefficient which falls in between the thermal expansion coefficient of the second frame portion 4b and the thermal expansion coefficient of the wavelength converter 5. The selection of such a material for the adhesive portion 7 makes it possible to avoid that, when the second frame portion 4b and the wavelength converter 5 are thermally expanded, separation takes place between them due to their difference in thermal expansion coefficient. That is, good connection can be maintained between the second frame portion 4b and the wavelength converter 5.

Since the adhesive portion 7 is applied so as to reach as far as the end of the lower surface of the wavelength converter 5, it follows that the area of application of the adhesive portion 7 is large enough to connect the second frame portion 4b with the wavelength converter 5 firmly. In consequence, the strength of connection between the second frame portion 4b and the wavelength converter 5 can be increased. This makes it possible to protect the wavelength converter 5 from distortion, and thereby prevent fluctuations of the optical distance between the light-emitting element 3 and the wavelength converter 5 effectively.

Moreover, the end of the wavelength converter 5 is located above the shoulder BU of the second frame portion 4b, so that the wavelength converter 5 is surrounded, at its side end, by the second frame portion 4b. Therefore, light which has been emitted from the light-emitting element 3 and found its way into the wavelength converter 5 may reach as far as the end in the interior of the wavelength converter 5. In this case, the light traveling from the end of the wavelength converter 5 toward the second frame portion 4b is caused to reflect at the second frame portion 4b, whereupon the reflected light can be returned into the wavelength converter 5 once again. In consequence, the light which has returned into the wavelength converter 5 is conducive to excitation of fluorescent substances. This makes it possible to enhance the light output capability of the light-emitting device 1.

The wavelength converter 5 is designed to give forth light through the excitation of fluorescent substances contained therein that takes place upon the entrance of excitation light emitted from the light-emitting element 3. The wavelength converter 5 is made for example of silicone resin, acrylic resin, or epoxy resin that contains a blue phosphor for giving forth fluorescence ranging in wavelength from 430 nm to 490 nm for example, a green phosphor for giving forth fluorescence ranging in wavelength from 500 nm to 560 nm for example, a yellow phosphor for giving forth fluorescence ranging in wavelength from 540 nm to 600 nm for example, and a red phosphor for giving forth fluorescence ranging in wavelength from 590 nm to 700 nm for example. Note that the phosphors are dispersed uniformly in the wavelength converter 5. The thickness of the wavelength converter 5 is adjusted to fall in a range of 0.3 mm or more to 1 mm or less.

Moreover, the wavelength converter 5 is made to have a uniform thickness throughout its entirety. For example, the thickness of the wavelength converter 5 is adjusted to fall in a range of 0.7 mm or more and 3 mm or less. In this regard, "uniformity in thickness" is construed as encompassing thickness deviation ranging downwardly from 0.1 mm. By virtue of the thickness uniformity of the wavelength converter 5, the quantity of excited light can be rendered uniform throughout the wavelength converter 5. This makes it possible to suppress unevenness in luminosity in the wavelength converter 5.

According to the present embodiment, the excitation light emitted from the light-emitting element 3 is applied to the entire lower surface of the wavelength converter 5. This makes it possible to increase the wavelength conversion efficiency of the wavelength converter 5, and thereby increase the luminous efficiency of the light-emitting device 1. Moreover, the excitation light totally reflected from the wavelength converter 5 is diffusely reflected from the upper surface of the first frame portion 4a once again so as to be applied to the entire lower surface of the wavelength converter 5. This makes it possible to increase the wavelength conversion efficiency of the wavelength converter 5, and thereby increase the luminous efficiency of the light-emitting device 1.

Moreover, since the lower surface of the wavelength converter 5 can be wholly irradiated with the excitation light, it is possible to render the amount of excitation of the fluorescent substances within the wavelength converter 5 uniform throughout the entire surface of the wavelength converter 5 when viewed in a plan view. In consequence, the uniformity of light acquired from the wavelength converter 5 can be enhanced.

It should be understood that the application of the invention is not limited to the specific embodiment described heretofore, and that many modifications and variations of the invention are possible within the scope of the invention.

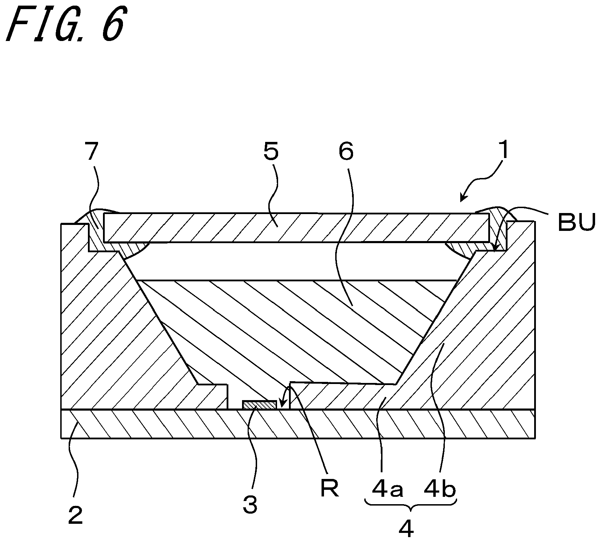

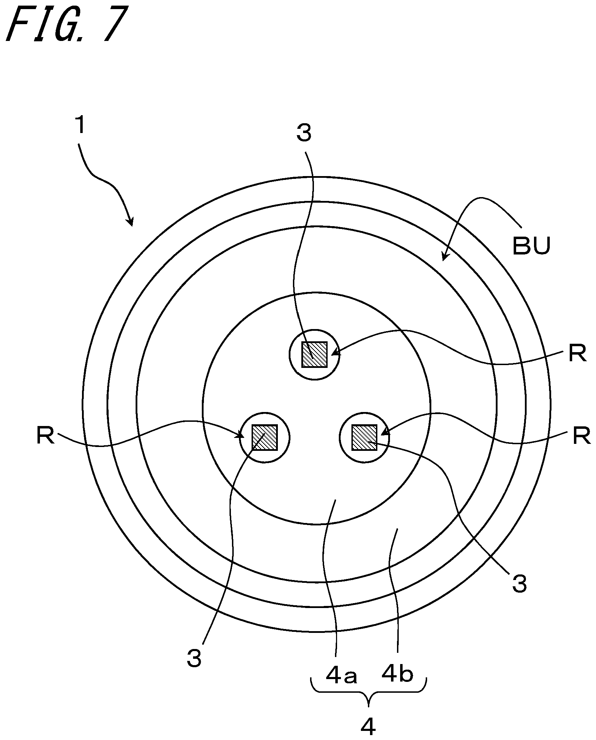

Fig. 6 is a sectional view of a modified example of the light-emitting device 1. Fig. 7 is a plan view of the light-emitting device 1 shown in Fig. 6. In Fig. 6, there is shown the section of one of light-emitting elements as shown in Fig. 7.

While, in the above-mentioned embodiment, a single light-emitting element 3 is placed on the substrate 2, a plurality of light-emitting elements 3 can be placed on the substrate 2. For example, as shown in Fig. 6, it is possible to place three light-emitting elements 3 on the substrate 2.

As shown in Fig. 7, the frame 4 disposed on the substrate 2 is provided with a plurality of mounting regions R where the light-emitting elements 3 are mounted, respectively. The first frame portion 4a, which is part of the frame 4 surrounding the individual light-emitting elements 3, is so designed that the upper end of the inner wall surface is higher in level than the upper surface of the light-emitting element 3. Moreover, the second frame portion 4b, which is part of the frame 4, is disposed on the first frame portion 4a. In the second frame portion 4b, the inner periphery is so shaped as to extend at an outward incline from the lower end of the inner periphery to the upper end thereof, and the lower end of the inner periphery is located outwardly beyond the inner wall surface of the first frame portion 4a.

As shown in Fig. 7, each of the plurality of light-emitting elements 3 is surrounded by a confined space area. Therefore, excitation light emitted from the light-emitting element 3 is applied to the entire lower surface of the wavelength converter 5 with a wider intensity distribution. Moreover, when the construction is viewed in a transparent plan view, the light-emitting element 3 is displaced from the center of the wavelength converter 5. In this way, the lower surface of the wavelength converter 5 can be wholly irradiated with the excitation light effectively. This makes it possible to increase the wavelength conversion efficiency of the wavelength converter 5, and thereby attain increased luminous efficiency.

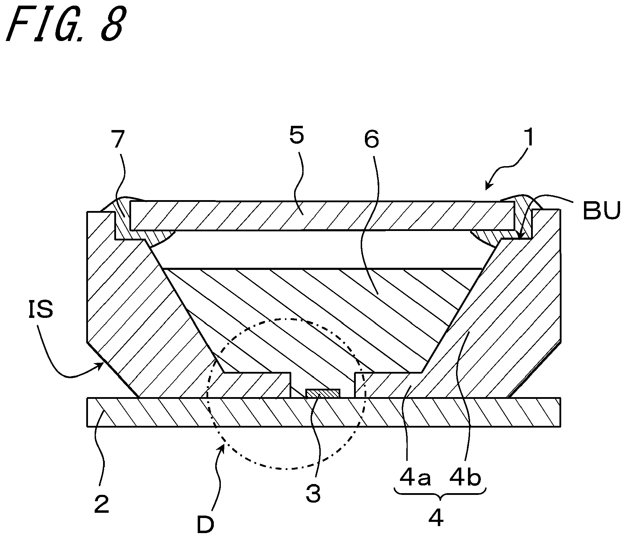

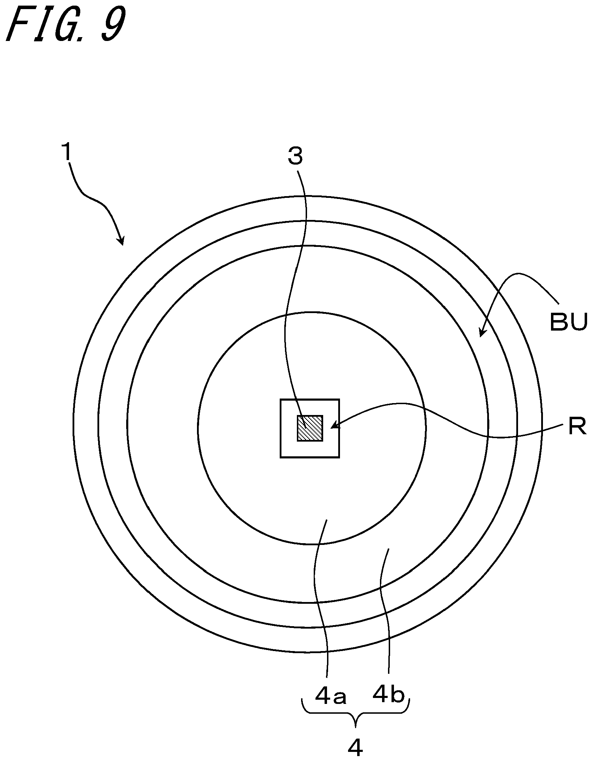

Fig. 8 is a sectional view of a modified example of the light-emitting device 1. Fig. 9 is a plan view of the light-emitting device 1 shown in Fig. 8. While, in the above-mentioned embodiment, the whole of the outer wall surface of the frame 4 is disposed in an upstanding state so as to be substantially perpendicular to the upper surface of the substrate 2, the invention is not so limited. For example, as shown in Fig. 8, in the frame 4 as viewed in a sectional view, part of its outer wall surface can be formed as a slant surface IS which is so shaped as to extend at an inward incline from top to bottom.

With the formation of the slant surface IS at part of the outer wall surface of the frame 4, for example, where the frame 4 is constructed of a light-transmittable member, such as aluminum oxide, through which light emitted from the light-emitting element 3 is transmitted, the light emitted from the light-emitting element 3 is, after passing through the frame 2, reflected from the slant surface IS in a direction toward the wavelength converter 5. After the reflection, the light emitted from the light-emitting element is transmitted through the frame 4 so as to enter the wavelength converter 5 where it is subjected to wavelength conversion. This affords the advantage of enhancement in the optical output capability of the light-emitting device 1. Note that the slant surface IS is inclined at an angle of, for example, greater than or equal to 10°, but smaller than or equal to 80° with respect to the upper surface of the substrate 2.

While, in the above-mentioned embodiment, the inner wall surface of the first frame portion 4a of the frame 4 is circularly shaped when viewed in a plan view, the invention is not so limited. For example, as shown in Fig. 9, the inner wall surface of the first frame portion 4a can be rectangularly shaped when viewed in a plan view. Moreover, the light-emitting element 3 is rectangularly shaped when viewed in a plan view. The light-emitting element 3 is so placed that each of the four corners thereof is opposed to its respective one of the four corners of the inner wall surface of the first frame portion 4a when viewed in a plan view.

Since the light-emitting element 3 is rectangular in shape when viewed in a plan view, where the inner wall surface of the first frame portion 4a is rectangularly shaped when viewed in a plan view, the number of locations at the inner wall surface that are equidistant from the side surface of the light-emitting element 3 becomes the largest. Thus, by placing the light-emitting element 3 so that its four corners are opposed to their respective corners of the inner wall surface of the first frame portion 4a, it is possible to increase the number of locations at the inner wall surface of the first frame portion 4a that are equidistant from the side surface of the light-emitting element 3, and thereby allow, of the light beams emitted from the light-emitting element 3, many of the light beams traveling in the planar direction to reflect from the inner wall surface of the first frame portion 4a. In consequence, the light reflected from the inner wall surface of the first frame portion 4a can be applied evenly to the entire lower surface of the wavelength converter 5; wherefore the light conversion efficiency can be increased.

Moreover, by configuring the first frame portion 4a so that its inner wall surface is rectangular in shape when viewed in a plan view, as well as by configuring the second frame portion 4b so that its inner periphery is circular in shape when viewed in a plan view, the light beams that have been emitted from the light-emitting element 3 and reflected from the inner wall surface of the first frame portion 4a are caused to travel the same distance so as to be applied evenly to the entire lower surface of the wavelength converter 5. Moreover, the light beams that have been reflected from the lower surface of the wavelength converter 5 and reached the second frame portion 4b are reflected radially from the circularly-shaped inner periphery of the second frame portion 4b in a rotationally symmetrical manner with respect to the optical axis of the light-emitting element 3 so as to uniformly enter the wavelength converter 5. In consequence, the light beams emitted from the light-emitting element 3 uniformly enter the wavelength converter 5; wherefore the conversion efficiency of the wavelength converter 5 can be increased, and also the optical output capability of the light-emitting device 1 can be enhanced.

### <Method of manufacturing Light-emitting device>

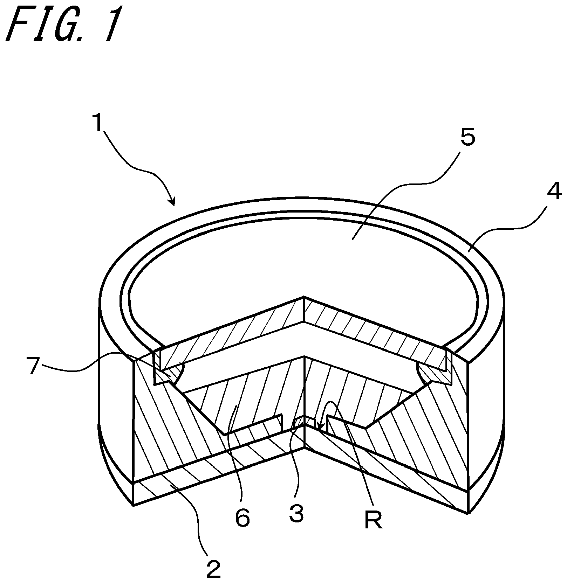

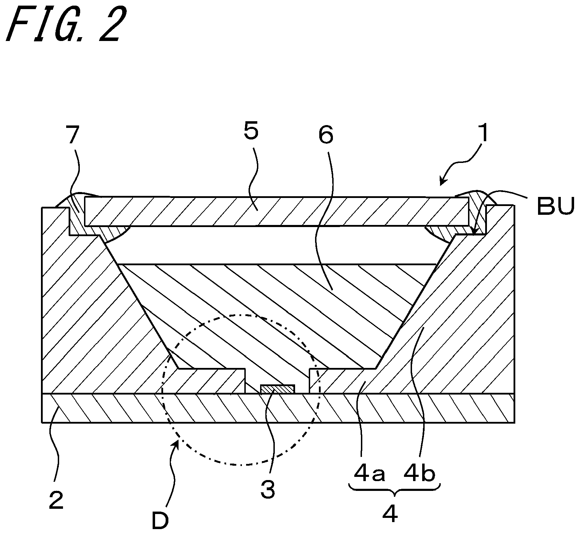

Now, a description will be given below as to a manufacturing method for the light-emitting device as shown in Fig. 1 or Fig. 2.

To begin with, the substrate 2 and the frame 4 are prepared. For example, in the case of forming the substrate 2 and the frame 4 from sintered aluminum oxide, an organic binder, a plasticizer or a solvent, and so forth are admixed in raw material powder of aluminum oxide to obtain a mixture.

Subsequently, the mixture is charged into mold forms for the substrate 2 and the frame 4. Following the completion of drying process, unsintered molded products of the substrate 2 and the frame 4 are taken out.

Subsequently, powder of high-melting-point metal such for example as tungsten or molybdenum is prepared for use. An organic binder, a plasticizer or a solvent, and so forth are admixed in the powder to obtain a metal paste. The metal paste is printed in a predetermined pattern onto ceramic green sheets constituting the substrate 2 and is then fired to form a wiring pattern. Moreover, the frame 4 is fabricated by charging a mixture of ceramic powder and a binder into a mold form, and then sintering the mixture.

Next, after the light-emitting element 3 is mounted on the wiring pattern on the substrate 2, the frame 4 is bonded onto the substrate via an adhesive so as to surround the light-emitting element 3.

Moreover, for example, silicone resin is charged into the region surrounded by the frame 4. The silicone resin is cured to thereby form the sealing resin 6.

Next, the wavelength converter 5 is prepared. The wavelength converter 5 can be formed by mixing fluorescent substances in resin in an uncured state, and shaping the mixture by means of a sheet molding technique such for example as the doctor blade method, the die coater method, the extrusion method, the spin coating method, or the dipping method. For example, the wavelength converter 5 can be obtained by charging the uncured material for the wavelength converter 5 into a mold form, and taking it out of the mold form following the completion of curing process.

Then, the thusly prepared wavelength converter 5 is bonded onto the shoulder BU of the frame 4 via the adhesive portion 7 made for example of resin. In this way, the light-emitting device 1 can be manufactured.

## Claims

1. A light-emitting device, comprising:
a substrate (2) mounted with a light-emitting element (3);
a frame (4) disposed on the substrate (2), the frame (4) including:
a first frame portion (4a) formed on the substrate (2) so as to surround the light-emitting element (3), the first frame portion having an inner wall surface substantially perpendicular to an upper surface of the substrate (2), and
a second frame portion (4b) formed so as to surround the inner wall surface of the first frame portion (4a) when viewed in a plan view, the second frame portion (4b) having an inner periphery which is so shaped as to extend at an outward incline from a lower end of the inner periphery to an upper thereof; and
a wavelength converter (5) supported on the frame (4) so as to be opposed to the substrate (2) with a gap, **characterized in that** an upper end of the inner wall surface of the first frame portion is positioned at a level higher than a level of an upper surface of the light-emitting element and further **characterized in that** when a distance from the center of the light-emitting element (3) to the inner wall surface of the first frame portion (4a) is denoted by a, and the distance between the level (P1) of the lower surface of the light emitting element (3) and the level (P2) of the upper end of the inner wall surface of the first frame portion (4a) is denoted by *b*, the distance a and the distance b are determined so as to fulfill a condition that *a* tan*θ* ≤ *b* ≤ a tan *β* wherein *θ* denotes a half-value angle relative to the luminous intensity distribution in the light-emitting element (3), and *β* denotes an angle at which 90%-luminosity with respect to peak luminosity is observed relative to the luminous intensity distribution in the light-emitting element (3).

2. The light-emitting device according to claim 1,
wherein the inner wall surface of the first frame portion (4a) is circularly shaped when viewed in a plan view.

3. The light-emitting device according to claim 1,
wherein the light-emitting element (3) is rectangularly shaped when viewed in a plan view, and
wherein the inner wall surface of the first frame portion (4a) is rectangularly shaped when viewed in a plan view.

4. The light-emitting device according to claim 3,
wherein the light-emitting element (3) is so placed that each of four corners thereof is opposed to its respective one of four corners of the inner wall surface of the first frame portion (4a) when viewed in a plan view.

5. The light-emitting device according to any one of claims 1 to 4,
wherein the inner periphery of the second frame portion (4b) is circularly shaped when viewed in a plan view.

6. The light-emitting device according to any one of claims 1 to 5,
wherein a distance (c) from the lower end of the inner periphery of the second frame portion (4b) to the upper end of the inner wall surface of the first frame portion (4a) is longer than a distance from a side surface of the light-emitting element (3) to the inner wall surface of the first frame portion (4a).

7. The light-emitting device according to any one of claims 1 to 6,
wherein the first frame portion (4a) and the second frame portion (4b) are formed integrally with each other.

8. The light-emitting device according to any one of claims 1 to 7,
wherein at least one of the substrate (2) and the frame (4) is made of a porous material.

9. The light-emitting device according to any one of claims 1 to 8,
wherein the light-emitting element (3) is placed singly inside the first frame portion (4a) of the frame (4).

10. The light-emitting device according to any one of claims 1 to 9,
wherein, in the frame (4) as viewed in a sectional view, part of its outer wall surface is formed as a slant surface (IS) which is so shaped as to extend at an inward incline from top to bottom.

## Patentansprüche

1. Eine lichtemittierende Vorrichtung, aufweisend:
ein Substrat (2), das mit einem lichtemittierenden Element (3) montiert / versehen ist,
einen Rahmen (4), der auf dem Substrat (2) angeordnet ist, wobei der Rahmen (4) aufweist:
einen ersten Rahmenabschnitt (4a), der auf dem Substrat (2) ausgebildet ist, um das lichtemittierende Element (3) zu umgeben, wobei der erste Rahmenabschnitt eine Innenwandfläche hat, die im Wesentlichen senkrecht zu einer oberen Fläche des Substrats (2) ist, und
einen zweiten Rahmenabschnitt (4b), der ausgebildet ist, um in einer Draufsicht betrachtet die Innenwandfläche des ersten Rahmenabschnitts (4a) zu umgeben, wobei der zweite Rahmenabschnitt (4b) einen Innenumfang hat, der derart geformt ist, um sich von einem unteren Ende des Innenumfangs zu einem oberen davon in einer Neigung nach außen zu erstrecken, und
einen Wellenlängenwandler (5), der auf dem Rahmen (4) abgestützt ist, um dem Substrat (2) mit einem Abstand gegenüberzuliegen,
**dadurch gekennzeichnet, dass** ein oberes Ende der Innenwandfläche des ersten Rahmenabschnitts auf einer Ebene höher als eine Ebene einer oberen Fläche des lichtemittierenden Elements positioniert ist, und ferner **dadurch gekennzeichnet, dass**, wenn ein Abstand von der Mitte des lichtemittierenden Elements (3) zu der Innenwandfläche des ersten Rahmenabschnitts (4a) mit a bezeichnet ist und der Abstand zwischen der Ebene (P1) der unteren Fläche des lichtemittierenden Elements (3) und der Ebene (P2) des oberen Endes der Innenwandfläche des ersten Rahmenabschnitts (4a) mit b bezeichnet ist, der Abstand *a* und der Abstand *b* derart bestimmt sind, um eine Bedingung zu erfüllen, dass a *tanθ ≤ b ≤ a tan β*, wobei *θ* einen Halbwertswinkel relativ zu der Lichtstärkeverteilung im lichtemittierenden Element (3) bezeichnet und *β* einen Winkel bezeichnet, in dem eine 90%-Leuchtkraft bezüglich der Spitzenleuchtkraft relativ zu der Lichtstärkeverteilung im lichtemittierenden Element (3) beobachtet wird.

2. Die lichtemittierende Vorrichtung gemäß Anspruch 1,
wobei die Innenwandfläche des ersten Rahmenabschnitts (4a) in einer Draufsicht betrachtet kreisförmig geformt ist.

3. Die lichtemittierende Vorrichtung gemäß Anspruch 1,
wobei das lichtemittierende Element (3) in einer Draufsicht betrachtet rechteckig geformt ist und
wobei die Innenwandfläche des ersten Rahmenabschnitts (4a) in einer Draufsicht betrachtet rechteckig geformt ist.

4. Die lichtemittierende Vorrichtung gemäß Anspruch 3,
wobei das lichtemittierende Element (3) so platziert ist, dass in einer Draufsicht betrachtet jede von vier Ecken davon ihrer jeweiligen einen von vier Ecken der Innenwandfläche des ersten Rahmenabschnitts (4a) gegenüberliegt.

5. Die lichtemittierende Vorrichtung gemäß irgendeinem der Ansprüche 1 bis 4,
wobei der Innenumfang des zweiten Rahmenabschnitts (4b) in einer Draufsicht betrachtet kreisförmig geformt ist.

6. Die lichtemittierende Vorrichtung gemäß irgendeinem der Ansprüche 1 bis 5,
wobei ein Abstand (c) von dem unteren Ende des Innenumfangs des zweiten Rahmenabschnitts (4b) zum oberen Ende der Innenwandfläche des ersten Rahmenabschnitts (4a) länger als ein Abstand von einer Seitenfläche des lichtemittierenden Elements (3) zu der Innenwandfläche des ersten Rahmenabschnitts (4a) ist.

7. Die lichtemittierende Vorrichtung gemäß irgendeinem der Ansprüche 1 bis 6,
wobei der erste Rahmenabschnitt (4a) und der zweite Rahmenabschnitt (4b) einstückig miteinander ausgebildet sind.

8. Die lichtemittierende Vorrichtung gemäß irgendeinem der Ansprüche 1 bis 7,
wobei mindestens eines von dem Substrat (2) und dem Rahmen (4) aus einem porösen Material hergestellt ist.

9. Die lichtemittierende Vorrichtung gemäß irgendeinem der Ansprüche 1 bis 8,
wobei das lichtemittierende Element (3) einzeln innerhalb des ersten Rahmenabschnitts (4a) des Rahmens (4) platziert ist.

10. Die lichtemittierende Vorrichtung gemäß irgendeinem der Ansprüche 1 bis 9,
wobei in dem Rahmen (4) in einer Schnittansicht betrachtet ein Teil von seiner Außenwandfläche als eine Neigungsfläche (IS) geformt ist, die derart geformt ist, um sich von oben nach unten in einer Neigung nach innen zu erstrecken.

## Revendications

1. Un dispositif électroluminescent, comportant :
un substrat (2) monté avec / muni d'un élément électroluminescent (3),
un cadre (4) disposé sur le substrat (2), le cadre (4) comportant :
une première partie de cadre (4a) formée sur le substrat (2) de manière à entourer l'élément électroluminescent (3), la première partie de cadre ayant une surface de paroi intérieure essentiellement perpendiculaire à une surface supérieure du substrat (2), et
une deuxième partie de cadre (4b) formée de manière à entourer la surface de paroi intérieure de la première partie de cadre (4a) lorsque vue dans une vue de dessus, la deuxième partie de cadre (4b) ayant une périphérie intérieure qui est formée de manière à s'étendre en pente vers l'extérieur d'une extrémité inférieure de la périphérie intérieure à une extrémité supérieure de celle-ci, et
un convertisseur de longueur d'onde (5) soutenu sur le cadre (4) de manière à être opposé au substrat (2) avec un espace,
**caractérisé en ce qu'**une extrémité supérieure de la surface de paroi intérieure de la première partie de cadre est positionnée à un niveau plus élevé qu'un niveau d'une surface supérieure de l'élément électroluminescent et **caractérisé en outre en ce que**, lorsqu'une distance à partir du centre de l'élément électroluminescent (3) jusqu'à la surface de paroi intérieure de la première partie de cadre (4a) est dénotée a et la distance entre le niveau (P1) de la surface inférieure de l'élément électroluminescent (3) et le niveau (P2) de l'extrémité supérieure de la surface de paroi intérieure de la première partie de cadre (4a) est dénotée *b,* la distance a et la distance *b* sont déterminées de manière à satisfaire à une condition selon laquelle a *tanθ ≤ b ≤ a tan β*, où *θ* dénote un angle de demi-valeur relativement à la répartition d'intensité lumineuse dans l'élément électroluminescent (3), et *β* dénote un angle sous lequel une luminosité de 90% par rapport à une luminosité de crête est observée relativement à la répartition d'intensité lumineuse dans l'élément électroluminescent (3).

2. Le dispositif électroluminescent selon la revendication 1,
dans lequel la surface de paroi intérieure de la première partie de cadre (4a) est de forme circulaire lorsque vue dans une vue de dessus.

3. Le dispositif électroluminescent selon la revendication 1,
dans lequel l'élément électroluminescent (3) est de forme rectangulaire lorsque vu dans une vue de dessus, et
dans lequel la surface de paroi intérieure de la première partie de cadre (4a) est de forme rectangulaire lorsque vue dans une vue de dessus.

4. Le dispositif électroluminescent selon la revendication 3,
dans lequel l'élément électroluminescent (3) est placé de telle manière que chacun de quatre coins de celui-ci est opposé à son coin respectif de quatre coins de la surface de paroi intérieure de la première partie de coin (4a) lorsque vu dans une vue de dessus.

5. Le dispositif électroluminescent selon l'une quelconque des revendications 1 à 4,
dans lequel la périphérie intérieure de la deuxième partie de cadre (4b) est de forme circulaire lorsque vue dans une vue de dessus.

6. Le dispositif électroluminescent selon l'une quelconque des revendications 1 à 5,
dans lequel une distance (c) à partir de l'extrémité inférieure de la périphérie intérieure de la deuxième partie de cadre (4b) à l'extrémité supérieure de la surface de paroi intérieure de la première partie de cadre (4a) est plus longue qu'une distance d'une surface latérale de l'élément électroluminescent (3) à la surface de paroi intérieure de la première partie de cadre (4a).

7. Le dispositif électroluminescent selon l'une quelconque des revendications 1 à 6,
dans lequel la première partie de cadre (4a) et la deuxième partie de cadre (4b) sont formées de manière intégrées l'une avec l'autre.

8. Le dispositif électroluminescent selon l'une quelconque des revendications 1 à 7,
dans lequel au moins un parmi le substrat (2) et le cadre (4) est formé d'une matière poreuse.

9. Le dispositif électroluminescent selon l'une quelconque des revendications 1 à 8,
dans lequel l'élément électroluminescent (3) est placé individuellement à l'intérieur de la première partie de cadre (4a) du cadre (4).

10. Le dispositif électroluminescent selon l'une quelconque des revendications 1 à 9,
dans lequel, dans le cadre (4) lorsque vu dans une vue en coupe, une partie de sa surface de paroi extérieure est formée comme une surface inclinée (IS) qui est formée de manière à s'étendre en pente vers l'intérieur de haut en bas.
